# EUROPÄISCHE PATENTSCHRIFT

(11) **EP 3 320 760 B1**
(45) Veröffentlichungstag und Bekanntmachung des Hinweises auf die Patenterteilung: **04.08.2021**
(21) Anmeldenummer: 16739391.7
(22) Anmeldetag: 21.06.2016
(51) Int. Cl.: H05K 1/02, H05K 1/11

(54) **LEITERPLATTE SOWIE VERFAHREN ZUR HERSTELLUNG EINER LEITERPLATTE**
PRINTED CIRCUIT BOARD AND METHOD FOR PRODUCING A PRINTED CIRCUIT BOARD
CARTE DE CIRCUITS IMPRIMÉS AINSI QUE PROCÉDÉ DE FABRICATION D'UNE CARTE DE CIRCUITS IMPRIMÉS

(30) Priorität: 06.07.2015 AT 505812015
(43) Veröffentlichungstag der Anmeldung: 16.05.2018
(73) Patentinhaber: ZKW Group GmbH, 3250 Wieselburg (AT)
(72) Erfinder: EDLINGER, Erik, 1090 Wien (AT); KIESLINGER, Dietmar, 2604 Theresienfeld (AT)
(74) Vertreter: Patentanwaltskanzlei Matschnig & Forsthuber OG
(86) Internationale Anmeldenummer: PCT/AT2016/050215
(87) Internationale Veröffentlichungsnummer: WO 2017/004632

(56) Entgegenhaltungen:
- EP-A2- 1 962 566
- DE-A1- 19 842 590
- GB-A- 2 304 999

## Beschreibung

Die Erfindung betrifft eine Leiterplatte zumindest umfassend eine isolierende Schicht und eine auf der isolierenden Schicht angeordnete und zu einer Kontaktfläche für eine auf die Leiterplatte zu bestückende elektronische Komponente strukturierte leitende Schicht sowie ein Verfahren zur Herstellung einer Leiterplatte.

Leiterplatten sind im Stand der Technik auch als printed circuit boards oder printed wiring boards bekannt und dienen dazu, elektrische, vor allem jedoch elektronische Komponenten platzsparend und stabil miteinander zu verbinden. Zu diesem Zweck weisen Leiterplatten auf isolierenden Schichten angeordnete leitende Schichten auf, die zur Verschaltung der Komponenten zu Leiterbahnen strukturiert sind und von den isolierenden Schichten voneinander getrennt sind. Die Komponenten können hierbei auf der Oberfläche der Leiterplatte angeordnet oder in die Leiterplatte eingebettet sein. Die fortschreitende Miniaturisierung von Leiterplatten zur Bereitstellung einer großen Zahl von Funktionalitäten in kleinbauenden Geräten führt zu nicht unerheblichen Zwängen hinsichtlich der Ableitung von Wärme, die von den Komponenten abgegeben wird und die sowohl zum Schutz der Komponenten als auch zum Schutz der Leiterplatte effizient abgeleitet und abgestrahlt werden muss. Besonders problematisch sind Komponenten, die besonders viel Wärme abgeben und so erfordern beispielsweise Leistungstransistoren und LEDs (light-emitting diodes), die im Fahrzeugbau zunehmend Verwendung finden, ein durchdachtes Wärmemanagement der Leiterplatte, um Überhitzung und damit einhergehend Beschädigungen der Leiterplatten zu vermeiden.

Im Stand der Technik ist es in diesem Zusammenhang bekannt, Wärmespreizflächen in unmittelbarer Nähe von elektronischen Komponenten vorzusehen. Wärmespreizflächen sind Kupferschichten oder auch kleine Metallplatten, die geeignet sind, die von der Komponente emittierte Wärme aufzunehmen und über eine größere Fläche als jene der Komponente abzustrahlen. Nachteilig an derartigen Strukturen ist jedoch, dass sie relativ viel Platz benötigen, der aufgrund der leitenden Natur der Wärmespreizflächen für das Anordnen von Leiterbahnen nicht mehr zur Verfügung stehen.

GB 2 304 999 A sowie EP 1 962 566 A2 offenbaren Leiterplatten gemäß dem Oberbegriff des Anspruchs 1 sowie Herstellungsverfahren gemäß dem Oberbegriff des Anspruchs 12.

Der Erfindung liegt daher die Aufgabe zugrunde, eine Leiterplatte anzugeben, die ein verbessertes Wärmemanagement aufweist.

Zur Lösung dieser Aufgabe ist die Leiterplatte der eingangs genannten Art erfindungsgemäß dadurch gekennzeichnet, dass die Leiterplatte im Bereich der Kontaktfläche (also innerhalb des Erstreckungsbereichs der Kontaktfläche) zumindest einen die Kontaktfläche und die isolierende Schicht durchsetzenden Kanal aufweist, der mit einem wärmeleitenden Material verfüllt ist. Im Zusammenhang mit der vorliegenden Erfindung ist ein Kanal als eine Ausnehmung in der Leiterplatte zu verstehen, die im Gegensatz zu einer einfachen Bohrung oder zu einem Schacht eine erhebliche horizontale Erstreckung in der Ebene der Leiterplatte hat. Ein solcher Kanal hat daher Ähnlichkeiten mit einem Langloch und die horizontale Erstreckung des Kanals dient dazu, einerseits eine möglichst große Masse an Metall zur Aufnahme von von der Komponente abgegebener Wärme bereitzustellen und andererseits die Wärme horizontal in der Ebene der Leiterplatte von der Komponente wegzuleiten, sodass die Wärme in einer von der Komponente entfernten Region der Leiterplatte abgestrahlt werden kann. Dadurch, dass der Kanal gemäß der vorliegenden Erfindung die Kontaktfläche und die isolierende Schicht der Leiterplatte durchsetzt und mit einem wärmeleitenden Material verfüllt ist, welches wärmeleitende Material in aller Regel ein Metall ist, kann die Wärme der Komponente nicht nur horizontal, d.h. in der Ebene der Leiterplatte, von der Komponente weggeleitet werden, sondern sie wird gleichzeitig auf die andere Seite der isolierenden Schicht geleitet und kann dort zusätzlich abgestrahlt werden. Anders als einfache Vias kann ein erfindungsgemäßer Kanal in der Leiterplatte nach den tatsächlichen oder zu erwartenden Wärmemengen, die von einer Komponente abgegeben werden, dimensioniert werden, so dass ein gezieltes Wärmemanagement für die jeweilige Leiterplatte realisierbar wird. Hierbei ist vorgesehen, dass Lötstopplack auf die Leiterplatte aufgebracht ist, wobei die zumindest eine Kontaktfläche einen Kontaktbereich umfasst, der zur Kontaktierung der elektronischen Komponente dient, wobei der zumindest eine Kanal sowie der Kontaktbereich freigestellt (also frei von Lötstopplack) ist.

Gemäß einer bevorzugten Ausführungsform ist die erfindungsgemäße Leiterplatte dahingehend weitergebildet, dass die Leiterplatte im Bereich der Kontaktfläche eine Mehrzahl von die Kontaktfläche und die isolierende Schicht durchsetzenden Kanälen aufweist, die mit einem wärmeleitenden Material verfüllt sind. Während es gemäß der vorliegenden Erfindung ausreichend sein kann, lediglich einen wie oben beschriebenen Kanal vorzusehen, ist es zu einer Steigerung der Effizienz der Wärmeableitung von der Komponente bei gleichzeitig möglichst günstiger Ausnutzung des auf einer Leiterplatte zur Verfügung stehenden Platzes bevorzugt, eine Mehrzahl von Kanälen einer Kontaktfläche zuzuordnen, wodurch pro Kontaktfläche eine unter Umständen möglichst große Metallmasse in die Leiterplatte eingebracht werden kann, ohne das kontinuierliche Gefüge der isolierenden Schicht der Leiterplatte, welche in wesentlichem Ausmaß zur mechanischen Stabilität der Leiterplatte beiträgt, durch einen zu voluminösen Kanal zu stören und dadurch zu schwächen. Gleichzeitig wird durch das Vorsehen einer Mehrzahl von Kanälen pro Kontaktfläche eine gleichmäßigere Verteilung der Wärme auf der Leiterplatte erzielt, was wiederum der Ausbildung von Temperaturspitzen und damit einhergehend Spannungen und folglich Schwächungen der Leiterplatte entgegen wirkt.

Wie bereits erwähnt, liegt ein Vorteil der Erfindung darin, dass ein Kanal, wie oben beschrieben und definiert, die Kontaktfläche und die isolierende Schicht der erfindungsgemäßen Leiterplatte durchsetzt, so dass die Wärme auch auf der der Komponente gegenüberliegenden Seite abgestrahlt werden kann. In diesem Zusammenhang ist es bevorzugt, wenn die Kontaktfläche entlang der Kanäle von einer Seite auf die andere gegenüberliegende Seite der isolierenden Schicht geführt ist. Dies bedeutet, dass die Kontaktfläche für die Komponente nicht nur auf jener Seite der Komponente angeordnet ist, die auch die die Wärme abgebende Komponente trägt, sondern dass die Kontaktfläche beispielsweise symmetrisch auf beiden Seiten der Leiterplatte ausgebildet ist bzw. auf beiden Seiten der isolierenden Schicht der Leiterplatte ausgebildet ist, so dass die Wärme durch den zumindest einen Kanal nicht nur auf die andere Seite der Leiterplatte gebracht wird, sondern dort auch flächig je nach Dimensionierung der Kontaktfläche verteilt werden kann und entsprechend effizient abgestrahlt wird.

Die überwiegende Mehrzahl von elektrischen und elektronischen Komponenten wird mit einer Mehrzahl, beispielsweise zwei oder drei, Kontaktflächen ein und derselben leitenden Schicht ankontaktiert, so dass es im Zusammenhang mit der vorliegenden Erfindung vorteilhaft erscheint, wenn die leitende Schicht zu einer Mehrzahl von Kontaktflächen für eine auf die Leiterplatte zu bestückende elektronische Komponente strukturiert ist und zu zumindest einer der Mehrzahl von Kontaktflächen zumindest ein die Kontaktfläche und die isolierende Schicht durchsetzender Kanal vorgesehen ist. Die bisher für lediglich eine Kontaktfläche beschriebene Anordnung von die Kontaktfläche und die isolierende Schicht durchsetzenden Kanälen kann daher auch für eine Mehrzahl von Kontaktflächen für ein und dieselbe Komponente oder aber auch für eine Mehrzahl von Kontaktflächen für unterschiedliche Komponenten angewendet werden, was wiederum der Ableitung von Wärme der jeweiligen Komponente zuträglich ist.

Eine weitere Verbesserung der Wärmeabstrahlung der Komponente wird dann erreicht, wenn die Kontaktfläche als Wärmespreizfläche ausgeführt ist. Dies bedeutet, dass die Kontaktfläche für die zu bestückende Komponente mit einer Fläche ausgebildet wird, die die eigentlich zur Ankontaktierung der Komponente notwendige Fläche wesentlich übersteigt, so dass nicht nur die elektrische Anbindung der Komponente durch die Dimensionierung der Kontaktfläche erreicht, sondern aufgrund der wesentlich größeren Ausführung auch eine horizontale Verteilung der von der Komponente abgegebenen Wärme möglich wird.

Gemäß einer bevorzugten Ausführungsform der vorliegenden Erfindung kann es vorgesehen sein, dass sich der zumindest eine Kanal über den Bereich der Kontaktfläche (also den Bereich, entlang dem sich die Kontaktfläche erstreckt) hinaus erstreckt. Ob nun die Kontaktfläche als einfache Kontaktfläche und daher im Wesentlichen mit jenem Flächeninhalt dimensioniert ist, der den Kontakten der zu bestückenden Komponente entspricht, oder ob die Kontaktfläche als Wärmespreizfläche ausgeführt ist, d.h. mit einem Flächeninhalt, der wesentlich größer ist als jener Flächeninhalt, der zur Bestückung bzw. zur Ankontaktierung der Komponente notwendig wäre, die oben beschriebenen erfindungsgemäßen Kanäle können in beiden Fällen dergestalt dimensioniert sein und insbesondere eine solche horizontale Erstreckung, d.h. eine solche Erstreckung in der Ebene der Leiterplatte haben, dass der Kanal über den Bereich der Kontaktfläche bzw. der Wärmespreizfläche hinausreicht und daher die Wärme der Komponente beliebig weit von der Komponente weggeleitet werden kann, solange der Kanal, der wie oben erwähnt, in aller Regel mit Metall verfüllt ist, keine Leiterbahnen kreuzt und vor allem keine Leiterbahnen der Leiterplatte in unerwünschter Weise kurzschließt.

Eine Reihe von Materialien und insbesondere Metallen kommt für die Verfüllung des die Kontaktfläche und die isolierende Schicht durchsetzenden Kanals in Frage. Eine hohe Wärmeleitfähigkeit ist für Kupfer, Silber und Gold anzunehmen, wobei Kupfer galvanisch abgeschieden werden kann. Es ist jedoch gemäß einer bevorzugten Ausführungsform der vorliegenden Erfindung vorgesehen, dass das wärmeleitende Material ausgewählt ist aus der Gruppe bestehend aus einem Lot, insbesondere SAC-Lot, Silber-Nanopaste, Wärmeleitkleber und Thermal Interface Material. Das Verfüllen des die Kontaktfläche und die isolierende Schicht durchsetzenden Kanals mit einem Lot ist deshalb von Vorteil, da in diesem Fall das Bestücken der Komponente auf die Leiterplatte, was in aller Regel durch Löten von statten geht, in einem gemeinsamen Verfahrensschritt mit dem Verfüllen des zumindest einen Kanals ausgeführt werden kann. Als besonders vorteilhaft zum Verlöten und gleichzeitig als besonders wärmeleitfähig hat sich SAC-Lot herausgestellt, welches ein Lot, enthaltend die Komponenten Zinn, Silber und Kupfer, ist. Die genannte Silber-Nanopaste ist unter dem Namen "Inkron Die Attach Material IDA-22" erhältlich und zeichnet sich durch eine hohe Wärmeleitfähigkeit aus. Die Silber-Nanopaste kann mittels Jet-Dispensing oder Schablonendruck aufgebracht werden. Ein handelsübliches Thermal Interface Material ist beispielsweise unter der Markenbezeichnungen "DOW Corning® TC-4025 Dispensable Thermal Pad" oder "Tpcm® 200sp" bekannt geworden.

Die Erfindung wurde bisher im Sinne der Minimalanforderung einer Leiterplatte beschrieben, die unter den Schutzbereich der wie in den Ansprüchen definierten Leiterplatte fallen soll. Es kann jedoch die Erfindung auch mit mehrlagigen Leiterplatten realisiert werden, sodass die erfindungsgemäße Leiterplatte bevorzugt eine Mehrzahl von isolierenden Schichten und leitenden Schichten umfasst. Hierbei können die isolierenden und leitenden Schichten, wie bisher beschrieben und definiert, zu Kontaktflächen und Kanälen verarbeitet sein, die die Kontaktflächen und die isolierenden Schichten durchsetzen und mit einem wärmeleitenden Material verfüllt sind, verarbeitet sein. Die isolierenden Schichten und die leitenden Schichten können jedoch auch Schichten sein, die einem herkömmlichen Aufbau einer Leiterplatte entsprechen und allgemein der Verschaltung von elektronischen Komponenten dienen. Die erfindungsgemäße Anordnung zumindest eines Kanals, der eine Kontaktfläche und eine isolierende Schicht durchsetzt, kann daher in Kombination mit mehrlagigen Leiterplatten eingesetzt werden. Der Kanal kann also die gesamte Mehrschichtleiterplatte durchsetzen oder senkrecht zur Leiterplattenoberfläche an einer Zwischenschicht, insbesondere an einer wärmeleitenden Schicht, enden.

Gemäß einer bevorzugten Ausführungsform ist es vorgesehen, dass der zumindest eine Kanal auf einer Seite der Leiterplatte mit einer isolierenden Schicht abgeschlossen bzw. verdeckt ist, in welchem Fall der Kanal gemäß der vorliegenden Erfindung auch als Graben angesprochen werden kann.

Zudem kann vorgesehen sein, dass der Kanal mit wärmeleitfähigen Material ausgekleidet ist, wobei insbesondere seine Seitenfläche metallisch, bevorzugt mit Kupfer, beschichtet ist. Die Auskleidung ist zumindest an der Kanalwand vorgesehen. Die Auskleidung mit einem wärmeleitfähigen Material wie beispielsweise Kupfer ermöglicht die Einwirkung von kapillaren Kräften auf ein oberhalb des Kanals angeordnetes Lotdepot, sodass diese nach seinem Schmelzen zumindest teilweise in dem Kanal aufgenommen wird und diesen ausfüllt. Außerdem wird durch diese Beschichtung die Verbindung des Lots mit der Printplattedeutlich verbessert.

Die vorliegende Erfindung dient vor allem der Ableitung von Wärme, die von elektronischen, aber auch von elektrischen Komponenten auf einer Leiterplatte abgegeben wird, weshalb die vorliegende Erfindung bevorzugt dahingehend weitergebildet ist, dass die Leiterplatte mit einer elektronischen Komponente, insbesondere einer LED, einer Laserdiode und/oder einer SMD-Komponente bestückt ist. LEDs werden insbesondere im Fahrzeugbau zunehmend zur Herstellung von leistungsfähigen Scheinwerfereinheiten verbaut, wobei diese LEDs überaus große Wärmemengen abgeben und eine effiziente Ableitung der Wärme zum Schutz der Leiterplatte von wesentlicher Bedeutung ist. Dasselbe gilt für Laserdioden, welche ebenfalls zunehmend als Leuchtmittel für Fahrzeugscheinwerfer an Bedeutung gewinnen. Die vorliegende Erfindung kann hier einen hervorragenden Beitrag leisten und daher mit größtmöglichem Nutzen eingesetzt werden.

Das erfindungsgemäße Verfahren zur Herstellung einer Leiterplatte, wie soeben definiert, zeichnet sich durch folgende Schritte aus:
Bereitstellen einer isolierenden Schicht und einer mit der isolierenden Schicht verbundenen leitenden Schicht,
Herstellen zumindest eines die leitende und die isolierende Schicht durchsetzenden Kanals,
Auskleiden des Kanals mit wärmeleitfähigem Material,
Strukturieren der leitenden Schicht zu einer Kontaktfläche für eine zu bestückende elektronische Komponente,
Bereitstellen eines Lotdepots in zumindest minimaler Überlappung mit den Kontaktflächen,
Aufsetzen der elektronischen Komponente,
Aufschmelzen des Lots und Abkühlen.

Das Bereitstellen einer isolierenden Schicht mit einer darüber liegenden leitenden Schicht erfolgt nach Methoden, die dem Fachmann auf dem Gebiet der Herstellung von Leiterplatten bestens bekannt sind. Hierzu zählen Laminierverfahren. In der Folge kann die leitende und die isolierende Schicht mit jeder brauchbaren Methode bearbeitet werden, um zumindest einen diese Schichten durchsetzenden Kanal herzustellen. Zu diesen Methoden zählen insbesondere Bohren und Fräsen sowie Laserschnittverfahren. Anschließend wird der Kanal mit einem wärmeleitfähigen Material ausgekleidet, beispielsweise werden die Seitenfläche und gegebenenfalls die Bodenfläche des Kanals durch galvanische Abscheidung von Cu metallisch bedeckt. In diesem Bearbeitungszustand wird die leitende Schicht an der Oberseite zu einer Kontaktfläche für eine zu bestückende elektronische Komponente strukturiert. Dazu werden bspw. fotolithographische Verfahren, wie sie zur Herstellung von Leiterbahnen und Kontaktflächen üblich sind, verwendet. Anschließend wird ein Lotdepot, d.h. eine genau bemessene Menge festen Lots, in zumindest minimaler Überlappung mit der Kontaktfläche bzw. den Kontaktflächen, die für die Kontaktierung der Komponente vorgesehen ist bzw. sind, angeordnet und die elektronische Komponente in dem Bereich über der Kontaktfläche angeordnet, wobei sich die elektronische Komponente am Lotdepot abstützen kann. Das Lotdepot enthält pastenartige Anteile, die gedruckt werden können, und gegebenenfalls zusätzlich feste Anteile wie Lötklötzchen, die bestückt werden können. Eine nur teilweise Überlappung der Lotdepots mit den Kontaktflächen ist insofern von Vorteil, als überschüssiges Flussmittel in den Bereichen, in denen keine Benetzung vorhanden ist, entweichen kann, ohne den Fluss des Lots in die gewünschten Bereiche zu stören. Es erfolgt ein Aufschmelzen des Lots durch Erhöhung der Temperatur in der Umgebung der Komponente, wodurch das Lotdepot unter gleichzeitiger Ausgasung eines eventuell aufgebrachten Flussmittels im Bereich der Kanäle und der Kontaktflächen durch Kapillarkräfte und durch die Schwerkraft in den Bereich des zumindest einen Kanals dringt und bei entsprechender Bemessung der Lotmenge gleichzeitig ein Verfüllen des zumindest einen Kanals und ein Ankontaktieren der Komponente erfolgt.

Bei der vorliegenden Erfindung wird vor dem Schritt des Bereitstellens eines Lotdepots ein Lötstopplack unter Freistellung von Bereichen der Kontaktfläche, die zur Kontaktierung der elektronischen Komponente dienen, aufgebracht. Dieser Schritt dient dazu, das später aufgeschmolzene Lot, welches in einem nachfolgenden Schritt entsteht, nur in jene Bereiche dringen zu lassen, die nicht mit dem Lötstopplack bedeckt sind, so dass eine unerwünschte Verteilung von Lot vermieden wird. Hierzu kann der Lötstopplack a priori unter Auslassung eines entsprechenden Bereichs aufgebracht werden oder der Lötstopplack wird vollflächig aufgebracht und danach die Freistellung hergestellt. Die freigestellten Bereiche umfassen dabei auch die Kanäle.

Gemäß einer bevorzugten Ausführungsform des erfindungsgemäßen Verfahrens wird vor dem Schritt des Bereitstellen eines Lotdepots der zumindest eine Kanal mit einem wärmeleitenden Material, insbesondere einem wärmeleitenden Material ausgewählt aus der Gruppe bestehend aus einem Lot, insbesondere SAC-Lot, Silber-Nanopaste, Wärmeleitkleber und Thermal Interface Material verfüllt. In diesem Fall erfolgt das Verfüllen der Kanäle und das Verlöten der Komponente nicht gleichzeitig, es wird jedoch eine größere Gestaltungsfreiheit bezüglich des Füllmaterials für die Kanäle erreicht.

Wie bereits im Zusammenhang mit der erfindungsgemäßen Leiterplatte erwähnt, kann bevorzugt eine Mehrzahl von die Kontaktfläche und die isolierende Schicht durchsetzenden Kanälen hergestellt werden, um eine entsprechende Verbesserung der Ableitung von durch die Komponente abgegebene Wärme zu erzielen. Während es gemäß der vorliegenden Erfindung ausreichend sein kann, lediglich einen wie oben beschriebenen Kanal vorzusehen, ist es zu einer Steigerung der Effizienz der Wärmeableitung von der Komponente bei gleichzeitig möglichst günstiger Ausnutzung des auf einer Leiterplatte zur Verfügung stehenden Platzes bevorzugt, eine Mehrzahl von Kanälen einer Kontaktfläche zuzuordnen, wodurch pro Kontaktfläche eine unter Umständen möglichst große Metallmasse in die Leiterplatte eingebracht werden kann, ohne das kontinuierliche Gefüge der isolierenden Schicht der Leiterplatte, welche in wesentlichem Ausmaß zur mechanischen Stabilität der Leiterplatte beiträgt, durch einen zu voluminösen Kanal zu stören und dadurch zu schwächen. Gleichzeitig wird durch das Vorsehen einer Mehrzahl von Kanälen pro Kontaktfläche eine gleichmäßigere Verteilung der Wärme auf der Leiterplatte erzielt, was wiederum der Ausbildung von Temperaturspitzen und damit einhergehend Spannungen und folglich Schwächungen der Leiterplatte entgegen wirkt.

Ebenso kann es bevorzugt vorgesehen sein, dass die leitende Schicht zu einer Mehrzahl von Kontaktflächen für eine auf die Leiterplatte zu bestückende elektronische Komponente strukturiert ist und zu zumindest einer der Mehrzahl von Kontaktflächen zumindest ein die Kontaktfläche und die isolierende Schicht durchsetzender Kanal hergestellt wird.

Gemäß einer bevorzugten Ausführungsform der vorliegenden Erfindung wird der zumindest eine Kanal über den Bereich der Kontaktfläche hinaus gezogen. Ob nun die Kontaktfläche als einfache Kontaktfläche und daher im Wesentlichen mit jenem Flächeninhalt dimensioniert ist, der den Kontakten der zu bestückenden Komponente entspricht, oder ob die Kontaktfläche als Wärmespreizfläche ausgeführt ist, d.h. mit einem Flächeninhalt, der wesentlich größer ist als jener Flächeninhalt, der zur Bestückung bzw. zur Ankontaktierung der Komponente notwendig wäre, die oben beschriebenen erfindungsgemäßen Kanäle können in beiden Fällen dergestalt dimensioniert sein und insbesondere eine solche horizontale Erstreckung, d.h. eine solche Erstreckung in der Ebene der Leiterplatte haben, dass der Kanal über den Bereich der Kontaktfläche bzw. der Wärmespreizfläche hinausreicht und daher die Wärme der Komponente beliebig weit von der Komponente weggeleitet werden kann, solange der Kanal, der wie oben erwähnt, in aller Regel mit Metall verfüllt ist, keine Leiterbahnen kreuzt und vor allem keine Leiterbahnen der Leiterplatte kurzschließt.

Das Lotdepot besteht gemäß einer bevorzugten Ausführungsform der vorliegenden Erfindung aus SAC-Lot. Das Verfüllen des die Kontaktfläche und die isolierende Schicht durchsetzenden Kanals mit einem Lot ist deshalb von Vorteil, da in diesem Fall das Bestücken der Komponente auf die Leiterplatte, was in aller Regel durch Löten von statten geht, in einem gemeinsamen Verfahrensschritt mit dem Verfüllen des zumindest einen Kanals ausgeführt werden kann. Als besonders vorteilhaft zum Verlöten und gleichzeitig als besonders wärmeleitfähig hat sich SAC-Lot herausgestellt, welches ein Lot, enthaltend die Komponenten Zinn, Silber und Kupfer, ist.

Die Erfindung wird nachfolgend anhand eines in der Zeichnung schematisch dargestellten Ausführungsbeispiels näher erläutert. In dieser zeigen
Fig. 1a eine schematische Draufsicht auf ein Zwischenprodukt bei der Herstellung einer erfindungsgemäßen Leiterplatte,
Fig. 1b einen Querschnitt gemäß der strichpunktierten Linie der Fig. 1a durch das genannte Zwischenprodukt,
Fig. 2 eine perspektivische Ansicht, teilweise im Schnitt, durch ein Zwischenprodukt gemäß der Fig. 1a und 1b,
Fig. 3 ein Zwischenprodukt bei der Herstellung einer erfindungsgemäßen Leiterplatte, bei der Lotdepots und eine Komponente bereits aufgesetzt wurden, und
die Fig. 4a und 4b eine Draufsicht nach dem Aufschmelzen des Lots sowie einen Schnitt nach dem Aufschmelzen des Lots.

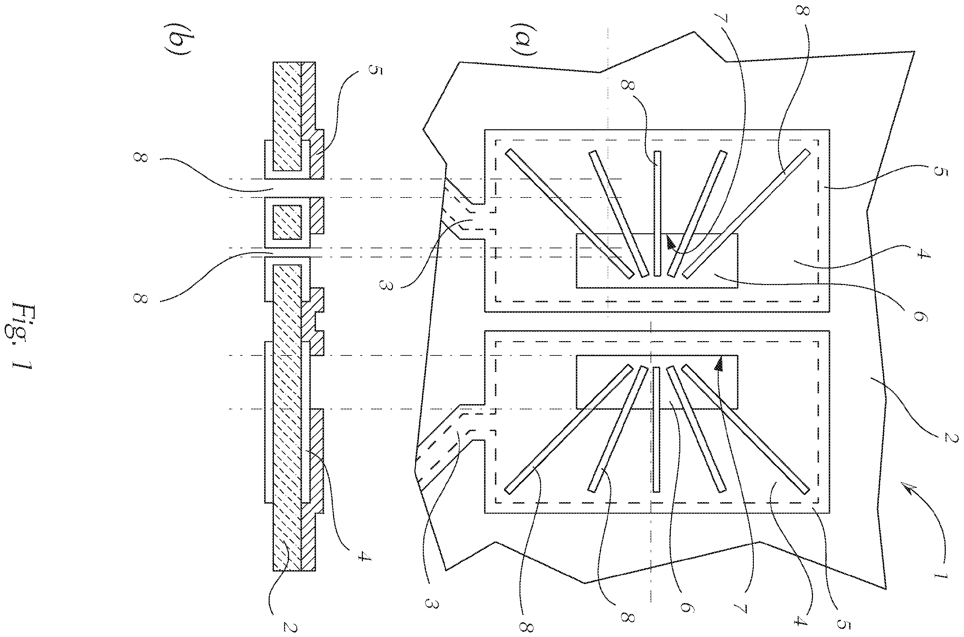

In Fig. 1a ist eine erfindungsgemäße Leiterplatte mit dem Bezugszeichen 1 bezeichnet. Die Leiterplatte besteht im Wesentlichen aus einer isolierenden Schicht 2 sowie einer leitenden Schicht 3, die zu Leiterzügen und Kontaktflächen 4 für eine zu bestückende Komponente strukturiert ist. Die Kontaktflächen 4 sind in Fig. 1a mit strichlierten Linien dargestellt, da ihre Umrißkanten unter Lötstopplack 5 verborgen sind und lediglich die für die Ankontaktierung einer Komponente notwendigen Kontaktbereiche 6 der Kontaktflächen 4 direkt einsehbar sind. In Fig. 1a sind daher die Kontaktflächen 4 für die zu bestückende Komponente als Wärmespreizflächen ausgeführt, da ihre Fläche wesentlich größer ist als jene Fläche, die zur reinen elektrischen Kontaktierung der Komponente notwendig wäre. Der Lötstopplack 5 ist unter Freistellung einer Aussparung 7 aufgebracht, um die Kontaktflächen 6 zum Kontaktieren der Komponente freizulassen. Die die Kontaktfläche 4 sowie die isolierende Schicht 2 durchsetzenden Kanäle sind mit dem Bezugszeichen 8 versehen und sind mit wie oben beschriebenen Verfahren herstellbar.

Fig. 1b gibt die Situation der Fig. 1a im Schnitt wieder und es ist zu erkennen, dass die Kontaktfläche 4 entlang der Kanäle 8 auf die andere Seite der isolierenden Schicht 2 geführt ist und dort symmetrisch angeordnet ist. Die Kanäle 8 durchsetzen sowohl die Kontaktfläche 4 als auch die isolierende Schicht 2 und sind, wie bereits erwähnt, in Fig. 1a und 1b noch nicht mit dem wärmeleitenden Material, insbesondere dem Metall, verfüllt.

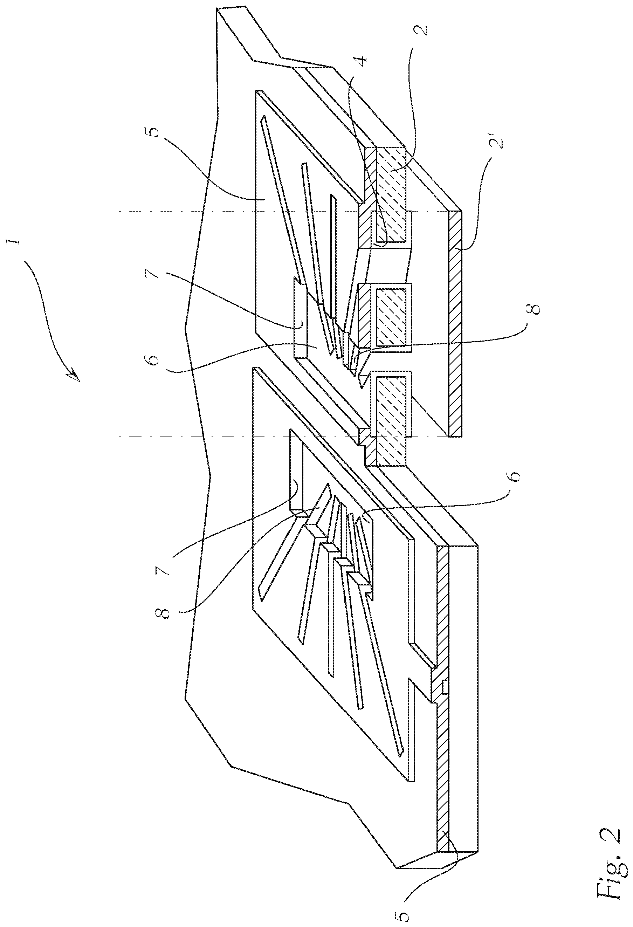

In Fig. 2 ist wiederum zu erkennen, dass die isolierende Schicht 2 und die darüber liegende Kontaktfläche 4 bei diesem Zwischenprodukt vom Lötstopplack 5 bedeckt sind, der jedoch so wie die Kontaktfläche 4 und die isolierende Schicht 2 bereits zur Ausbildung der Kanäle 8 durchsetzt ist. Mit 2' ist eine isolierende Schicht bezeichnet, die als zusätzliche isolierende Schicht auf dem erfindungsgemäßen Leiterplattenverbund aufgebracht werden kann, um die Kanäle 8 an der der Komponente gegenüberliegenden Seite abzuschließen.

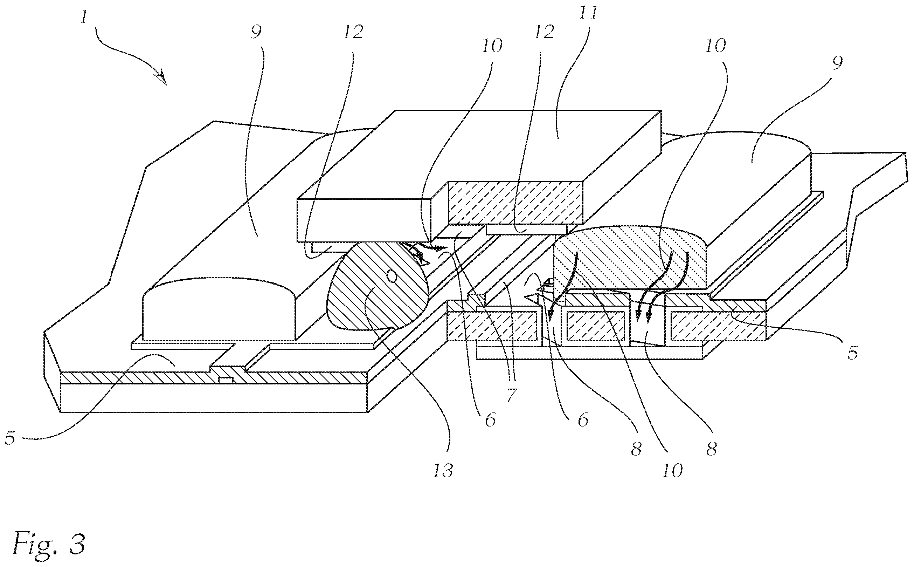

In Fig. 3 sind nun Lotdepots 9 auf dem Lötstopplack 5 neben der Aussparung 7 bereitgestellt, wobei Pfeile 10 anzeigen, dass bei entsprechender Erhöhung der Temperatur und damit einhergehend Aufschmelzen der Lotdepots 9 das verflüssigte Lot in die Kanäle 8 sowie in den Kontaktbereich 6 fließt. Die elektronische Komponente 11 liegt vor dem Aufschmelzen des Lots auf den Lotdepots 9 auf und wird von einem Klebepunkt 13 provisorisch festgehalten. Hierdurch bleibt beim Aufschmelzen der Lotdepots 9 die Komponente 11 in ihrer Höhen- und Horizontalposition bezüglich der Leiterplatte 1 festgehalten, so dass es nicht zu einem Absenken oder Einschwimmen der elektronischen Komponente 11 kommt. Die Kontaktierung der Kontaktpads 12 der elektronischen Komponente 11 durch das Lot aus den Lotdepots 9 ist dadurch sichergestellt, dass im Drucklayout der Leiterplatte 1 eine zumindest minimale Überlappung zwischen dem Lotdepot 9 und den Kontaktbereichen 6 auf der Leiterplatte 1 sowie den Kontaktpads 12 der elektronischen Komponente 11 vorgesehen ist und der Abstand zwischen den Kontaktpads 10 und dem Kontaktbereich 6 der Kontaktflächen 4 relativ gering ist, sodass es zu Kapillareffekten zwischen den Kontaktpads 12 und dem Kontaktbereich 6 kommt, und das Lot aus den Lotdepots 9 in diesen Bereichen zu den Kontaktpads hochgezogen wird.

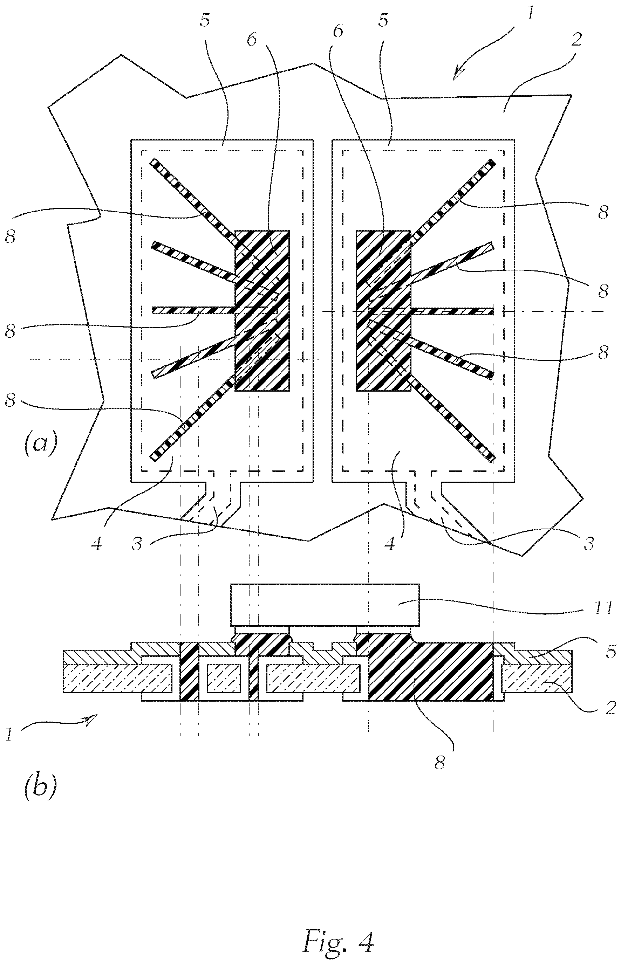

In Fig. 4a ist die Situation nach dem Aufschmelzen der Leiterplatte dargestellt, wobei jedoch zur besseren Draufsicht auf die Kanäle 8 die elektronische Komponente 11 nicht dargestellt ist. In Fig. 4a ist zu erkennen, dass sowohl die Kanäle 8 als auch die Kontaktbereiche 6 vollständig mit Lot verfüllt sind und die von der Komponente 11 abgegebene Wärme daher über den gesamten Bereich der als Wärmespreizfläche ausgeführten Kontaktfläche 4 für die zu bestückende Komponente 11 verteilt werden kann, wobei sich insbesondere aus Fig. 4b ergibt, dass ein großes Metallvolumen und daher eine große Metallmasse in den Kanälen 8 bereitgestellt werden kann, so dass die von der Komponente 11 aufgenommene Wärme in dieser Metallmasse dissipiert und insbesondere auch auf die andere Seite der Leiterplatte 1 gebracht werden kann. Auf diese Weise gelingt es, auch große Wärmemengen von elektronischen Komponenten wie LEDs zu verteilen und abzuleiten, sodass sich allgemein bei der erfindungsgemäßen Leiterplatte eine geringere punktuelle Belastung der Leiterplatte sowie auch der Komponente 11 ergibt, was einer längeren Betriebsdauer und Betriebssicherheit der Leiterplatte in hohem Maße zuträglich ist.

## Patentansprüche

1. Leiterplatte (1), umfassend eine isolierende Schicht (2) und eine auf der isolierenden Schicht (2) angeordnete leitende Schicht (3), die zu einer Kontaktfläche (4) für eine auf die Leiterplatte (1) zu bestückende elektronische Komponente (11) strukturiert ist, wobei die Leiterplatte (1) im Bereich der Kontaktfläche (4) zumindest einen die Kontaktfläche (4) und die isolierende Schicht (2) durchsetzenden Kanal (8) aufweist, dessen größte Erstreckung horizontal zur Leiterplatte verläuft und der mit einem wärmeleitenden Material verfüllt ist, **dadurch gekennzeichnet, dass** Lötstopplack auf die Leiterplatte (1) aufgebracht ist, wobei die zumindest eine Kontaktfläche (4) einen Kontaktbereich (6) umfasst, der zur Kontaktierung der elektronischen Komponente (11) dient, wobei der zumindest eine Kanal (8) sowie der Kontaktbereich (6) freigestellt ist.

2. Leiterplatte nach Anspruch 1, **dadurch gekennzeichnet, dass** die Leiterplatte (1) im Bereich der Kontaktfläche (4) eine Mehrzahl von die Kontaktfläche (4) und die isolierende Schicht (2) durchsetzenden voneinander beabstandeten Kanälen (8) aufweist, die mit einem wärmeleitenden Material verfüllt sind.

3. Leiterplatte nach Anspruch 1 oder 2, **dadurch gekennzeichnet, dass** die Kontaktfläche (4) entlang der Kanäle (8) von einer Seite auf die andere Seite der isolierenden Schicht (2) geführt ist.

4. Leiterplatte nach einem der Ansprüche 1 bis 3, **dadurch gekennzeichnet, dass** die leitende Schicht (3) zu einer Mehrzahl von Kontaktflächen (4) für eine auf die Leiterplatte (1) zu bestückende elektronische Komponente (11) strukturiert ist und zu zumindest einer der Mehrzahl von Kontaktflächen (4) zumindest ein die zumindest eine Kontaktfläche (4) und die isolierende Schicht (2) durchsetzender Kanal (8) vorgesehen ist.

5. Leiterplatte nach einem der Ansprüche 1 bis 4, **dadurch gekennzeichnet, dass** die Kontaktfläche (4) als Wärmespreizfläche ausgeführt ist.

6. Leiterplatte nach einem der Ansprüche 1 bis 5, **dadurch gekennzeichnet, dass** sich der zumindest eine Kanal (8) über die Kontaktfläche (4) hinaus erstreckt.

7. Leiterplatte nach einem der Ansprüche 1 bis 6, **dadurch gekennzeichnet, dass** das wärmeleitende Material ausgewählt ist aus der Gruppe bestehend aus einem Lot, insbesondere SAC-Lot, Silber-Nanopaste, Wärmeleitkleber und Thermal Interface Material.

8. Leiterplatte nach einem der Ansprüche 1 bis 7, **dadurch gekennzeichnet, dass** die Leiterplatte (1) eine Mehrzahl von wechselweise übereinander angeordneten isolierenden Schichten (2, 2') und leitenden Schichten (3) umfasst.

9. Leiterplatte nach einem der Ansprüche 1 bis 8, **dadurch gekennzeichnet, dass** der zumindest eine Kanal (8) auf einer Seite der Leiterplatte (1) mit einer isolierenden Schicht (2') abgeschlossen ist.

10. Leiterplatte nach einem der vorhergehenden Ansprüche, **dadurch gekennzeichnet, dass** der Kanal (8) mit wärmeleitfähigen Material ausgekleidet ist, wobei insbesondere seine Seitenfläche metallisch, bevorzugt mit Kupfer, beschichtet ist.

11. Leiterplatte nach einem der Ansprüche 1 bis 12, **dadurch gekennzeichnet, dass** die Leiterplatte (1) mit einer elektronischen Komponente (11), insbesondere einer LED, einer Laserdiode und/oder einer SMD-Komponente bestückt ist, indem die elektronische Komponente (11) mit zumindest einer Kontaktfläche (4) der Leiterplatte (1) elektrisch verbunden ist.

12. Verfahren zur Herstellung einer Leiterplatte nach Anspruch 11 durch die Schritte:
Bereitstellen einer isolierenden Schicht (2) und einer mit der isolierenden Schicht (2) verbundenen leitenden Schicht (3)
Herstellen zumindest eines die leitende (3) und die isolierende Schicht (2) durchsetzenden Kanals (8), dessen größte Erstreckung horizontal zur Leiterplatte verläuft
Auskleiden des zumindest einen Kanals (8) mit wärmeleitfähigem Material, insbesondere durch Anbringen einer Kupferbeschichtung, beispielsweise durch galvanisieren,
Strukturieren der leitenden Schicht (3) zu zumindest einer Kontaktfläche (4) für eine zu bestückende elektronische Komponente (11)
Bereitstellen eines Lotdepots (9) auf die leitende Schicht (3), wobei das Lotdepot (9) zumindest eine minimale Überlappung mit der zumindest einen Kontaktfläche (4) aufweist,
Aufsetzen der elektronischen Komponente (11) auf die zumindest eine Kontaktfläche (4),
Aufschmelzen und nachfolgendes Abkühlen des Lotdepots (9) zur elektrischen und mechanischen Verbindung der elektronischen Komponente (11) mit der zumindest einen Kontaktfläche (4), **dadurch gekennzeichnet, dass** vor dem Schritt des Bereitstellens eines Lotdepots (9) ein Lötstopplack auf die Leiterplatte (1) aufgebracht wird, wobei die zumindest eine Kontaktfläche (4) einen Kontaktbereich (6) umfasst, der zur Kontaktierung der elektronischen Komponente (11) dient und dergestalt angeordnet ist, dass dieser mit dem nachfolgend aufzubringenden Lotdepot (9) überlappt, wobei der zumindest eine Kanal (8) sowie der Kontaktbereich (6) freigestellt wird.

13. Verfahren nach Anspruch 12, **dadurch gekennzeichnet, dass** vor dem Schritt des Bereitstellen eines Lotdepots der zumindest eine Kanal (8) mit einem wärmeleitenden Material, insbesondere einem wärmeleitenden Material ausgewählt aus der Gruppe bestehend aus einem Lot, insbesondere SAC-Lot, Silber-Nanopaste, Wärmeleitkleber und Thermal Interface Material, verfüllt wird.

14. Verfahren nach Anspruch 13, **dadurch gekennzeichnet, dass** eine Mehrzahl von die Kontaktfläche (4) und die isolierende Schicht (2) durchsetzenden voneinander beabstandeten Kanälen (8) hergestellt wird.

15. Verfahren nach einem der Ansprüche 12 bis 14, **dadurch gekennzeichnet, dass** die leitende Schicht (3) zu einer Mehrzahl von Kontaktflächen (4) für eine auf die Leiterplatte (1) zu bestückende elektronische Komponente (11) strukturiert ist und zu zumindest einer der Mehrzahl von Kontaktflächen (4) zumindest ein die zumindest eine Kontaktfläche (4) und die isolierende Schicht (2) durchsetzender Kanal (8) hergestellt wird.

16. Verfahren nach einem der Ansprüche 12 bis 15, **dadurch gekennzeichnet, dass** der zumindest eine Kanal (8) über den Bereich der Kontaktfläche (4) hinaus gezogen wird.

17. Verfahren nach einem der Ansprüche 12 bis 16, **dadurch gekennzeichnet, dass** das Lotdepot (9) aus SAC-Lot besteht.

## Claims

1. Printed circuit board (1), comprising an insulating layer (2) and a conductive layer (3) which is arranged on the insulating layer (2) and is structured to form a contact surface (4) for an electronic component (11) to be mounted on the printed circuit board (1), the printed circuit board (1) having, in the region of the contact surface (4), at least one channel (8) which passes through the contact surface (4) and the insulating layer (2), the largest extension of at least one channel (8) extends horizontally to the printed circuit and which is filled with a thermally conductive material, **characterized in that** solder resist is applied to the printed circuit board (1), the at least one contact surface (4) comprising a contact region (6) which serves to make contact with the electronic component (11), the at least one channel (8) and the contact region (6) being exposed.

2. Printed circuit board according to claim 1, **characterized in that** the printed circuit board (1) has, in the region of the contact area (4), a plurality of channels (8) which pass through the contact area (4) and the insulating layer (2), are spaced apart from one another and are filled with a thermally conductive material.

3. Printed circuit board according to claim 1 or 2, **characterized in that** the contact surface (4) is guided along the channels (8) from one side to the other side of the insulating layer (2).

4. Printed circuit board according to one of claims 1 to 3, **characterized in that** the insulating layer (3) is structured to form a plurality of contact areas (4) for an electronic component (11) to be mounted on the printed circuit board (1), and at least one channel (8) passing through the at least one contact area (4) and the insulating layer (2) is provided for at least one of the plurality of contact areas (4).

5. Printed circuit board according to one of claims 1 to 4, **characterized in that** the contact surface (4) is designed as a heat spreading surface.

6. Printed circuit board according to one of claims 1 to 5, **characterized in that** the at least one channel (8) extends beyond the contact surface (4).

7. Printed circuit board according to one of claims 1 to 6, **characterized in that** the thermally conductive material is selected from the group consisting of a solder, in particular SAC solder, silver nanopaste, thermally conductive adhesive and thermal interface material.

8. Printed circuit board according to one of claims 1 to 7, **characterized in that** the printed circuit board (1) comprises a plurality of insulating layers (2, 2') and conductive layers (3) arranged alternately one above the other.

9. Printed circuit board according to one of the claims 1 to 8, **characterized in that** the at least one channel (8) on one side of the printed circuit board (1) is closed off with an insulating layer (2').

10. Printed circuit board according to one of the preceding claims, **characterized in that** the channel (8) is lined with thermally conductive material, in particular its side surface being coated metallically, preferably with copper.

11. Printed circuit board according to one of the claims 1 to 12, **characterized in that** the printed circuit board (1) is equipped with an electronic component (11), in particular an LED, a laser diode and/or an SMD component, **in that** the electronic component (11) is electrically connected to at least one contact surface (4) of the circuit board (1).

12. Method of manufacturing a printed circuit board according to claim 11 by the steps of:
providing an insulating layer (2) and a conductive layer (3) bonded to the insulating layer (2),
producing at least one channel (8) passing through the conductive layer (3) and the insulating layer (2), the largest dimension of at least one channel (8) is horizontal to the printed circuit board lining the at least one channel (8) with a thermally conductive material, in particular by applying a copper coating, for example by electroplating,
structuring the conductive layer (3) to form at least one contact surface (4) for an electronic component (11) to be assembled,
providing a solder deposit (9) on the conductive layer (3), wherein the solder deposit (9) has at least a minimum overlap of at least a minimal overlap with the at least one contact surface (4),
placing the electronic component (11) on the at least one contact surface (4),
melting and subsequent cooling of the solder deposit (9) for the electrical and mechanical connection of the electronic component (11) to the at least one contact surface (4), **characterized in that** prior to the step of providing a solder deposit (9), a solder resist is applied to the printed circuit board (1), the at least one contact surface (4) comprising a contact region (6) which serves for contacting the electronic component (11) and is arranged in such a way that it overlaps with the solder deposit (9) to be subsequently applied, the at least one channel (8) and the contact region (6) being exposed.

13. Method according to claim 12, **characterized in that**, before the step of providing a solder deposit, the at least one channel (8) is filled with a thermally conductive material, in particular a thermally conductive material selected from the group consisting of a solder, in particular SAC solder, silver nanopaste, thermally conductive adhesive and thermal interface material.

14. Method according to claim 13, **characterized in that** a plurality of spaced-apart channels (8) is produced which pass through the contact surface (4) and the insulating layer (2).

15. Method according to any one of claims 12 to 14, **characterized in that** the insulating layer (3) is layer (3) is formed into a plurality of contact areas (4) for an electronic component (11) to be electronic component (11) to be mounted on the printed circuit board (1), and at least one channel (8) passing through the at least one contact surface (4) and the isolating layer (2) is produced for at least one of the plurality of contact surfaces (4).

16. method according to any one of claims 12 to 15, **characterized in that** the at least one channel (8) is drawn beyond the region of the contact surface (4).

17. process according to any one of claims 12 to 16, **characterized in that** the solder depot (9) consists of SAC solder.

## Revendications

1. Carte de circuit imprimé (1), comprenant une couche isolante (2) et une couche conductrice (3) qui est disposée sur la couche isolante (2) et est structurée pour former une surface de contact (4) pour un composant électronique (11) pour être montée sur la carte de circuit imprimé (1), la carte de circuit imprimé (1) comportant, au niveau de la surface de contact (4), au moins un canal (8) qui traverse la surface de contact (4) et l'isolant couche (2), la plus grande extension d'au moins un canal (8) s'étend horizontalement vers le circuit imprimé et qui est rempli d'un matériau thermoconducteur, **caractérisé en ce que** la résistance de soudure est appliquée sur la carte de circuit imprimé (1), le au moins une surface de contact (4) comprenant une région de contact (6) qui sert à établir un contact avec le composant électronique (11), le au moins un canal (8) et la région de contact (6) étant exposés.

2. Carte de circuit imprimé selon la revendication 1, **caractérisée en ce que** la carte de circuit imprimé (1) présente, dans la zone de la surface de contact (4), une pluralité de canaux (8) traversant la surface de contact (4) et la couche isolante (2), espacés les uns des autres et remplis d'un matériau thermoconducteur.

3. Carte de circuit imprimé selon la revendication 1 ou 2, **caractérisée en ce que** la surface de contact (4) est guidée le long des canaux (8) d'un côté à l'autre de la couche isolante (2).

4. Carte de circuit imprimé selon l'une des revendications 1 à 3, **caractérisée en ce que** la couche isolante (3) est structurée pour former une pluralité de zones de contact (4) pour un composant électronique (11) à monter sur la carte de circuit imprimé (1), et au moins un canal (8) passant par la au moins une zone de contact (4) et la couche isolante (2) est prévu pour au moins une de la pluralité de zones de contact (4).

5. Carte de circuit imprimé selon l'une des revendications 1 à 4, **caractérisée en ce que** la surface de contact (4) est conçue comme une surface de diffusion de chaleur.

6. Carte de circuit imprimé selon l'une quelconque des revendications 1 à 5, **caractérisée en ce que** le au moins un canal (8) s'étend au-delà de la surface de contact (4).

7. Carte de circuit imprimé selon l'une quelconque des revendications 1 à 6, **caractérisée en ce que** le matériau thermiquement conducteur est choisi dans le groupe constitué par une soudure, en particulier une soudure SAC, une nanopâte d'argent, un adhésif thermiquement conducteur et un matériau d'interface thermique.

8. Carte de circuit imprimé selon l'une quelconque des revendications 1 à 7, **caractérisée en ce que** la carte de circuit imprimé (1) comprend une pluralité de couches isolantes (2, 2') et de couches conductrices (3) disposées alternativement les unes sur les autres.

9. Carte de circuit imprimé selon l'une des revendications 1 à 8, **caractérisée en ce que** le au moins un canal (8) sur un côté de la carte de circuit imprimé (1) est terminé par une couche isolante (2').

10. Carte de circuit imprimé selon l'une des revendications précédentes, **caractérisée en ce que** le canal (8) est revêtu d'un matériau thermiquement conducteur, en particulier sa surface latérale étant revêtue de façon métallique, de préférence de cuivre.

11. Carte de circuit selon l'une des revendications 1 à 12, **caractérisée en ce que** la carte de circuit (1) est équipée d'un composant électronique (11), notamment une LED, une diode laser et/ou un composant CMS, **en ce que** le composant électronique (11) est relié électriquement à au moins une surface de contact (4) de la carte de circuit (1).

12. Procédé de fabrication d'une carte de circuit imprimé selon la revendication 11 par les étapes de:
fournir une couche isolante (2) et une couche conductrice (3) liées à la couche isolante (2),
produisant au moins un canal (8) passant à travers la couche conductrice (3) et la couche isolante (2), la plus grande dimension d'au moins un canal (8) est horizontale par rapport à la carte de circuit imprimé bordant l'au moins un canal (8) ) avec un matériau thermoconducteur, notamment par application d'un revêtement de cuivre, par exemple par galvanoplastie,
structurer la couche conductrice (3) pour former au moins une surface de contact (4) pour un composant électronique (11) à assembler,
fournir un dépôt de soudure (9) sur la couche conductrice (3), dans lequel le dépôt de soudure (9) a au moins un chevauchement minimum d'au moins un chevauchement minimal avec la au moins une surface de contact (4),
placer le composant électronique (11) sur la au moins une surface de contact (4),
fusion et refroidissement ultérieur du dépôt de soudure (9) pour la connexion électrique et mécanique du composant électronique (11) à la au moins une surface de contact (4),
**caractérisé en ce qu'**avant l'étape de réalisation d'un dépôt de soudure (9) , une réserve de soudure est appliquée sur la carte de circuit imprimé (1), la au moins une surface de contact (4) comprenant une région de contact (6) qui sert à entrer en contact avec le composant électronique (11) et est disposée de telle sorte qu'elle chevauche le dépôt de soudure (9) à appliquer ultérieurement, le au moins un canal (8) et la région de contact (6) étant exposés.

13. Procédé selon la revendication 12, **caractérisé en ce que**, avant l'étape de réalisation d'un dépôt de soudure, le au moins un canal (8) est rempli d'un matériau thermoconducteur, en particulier d'un matériau thermoconducteur choisi dans le groupe constitué par une soudure, en particulier une soudure SAC, une nanopâte d'argent, un adhésif thermoconducteur et un matériau d'interface thermique.

14. Procédé selon la revendication 13, **caractérisé en ce qu'**on réalise une pluralité de canaux (8) espacés les uns des autres, traversant la surface de contact (4) et la couche isolante (2).

15. Procédé selon l'une quelconque des revendications 12 à 14, **caractérisé en ce que** la couche isolante (3) est (3) est formé en une pluralité de surfaces de contact (4) pour un composant électronique (11) à être composant électronique (11) à monter sur la carte de circuit imprimé (1), et on réalise au moins un canal (8) traversant la au moins une surface de contact (4) et la couche isolante (2) pour au moins une de la pluralité de surfaces de contact (4).

16. Procédé selon l'une quelconque des revendications 12 à 15, **caractérisé en ce que** l'at au moins un canal (8) est dessiné au-delà de la région de la surface de contact (4).

17. Procédé selon l'une quelconque des revendications 12 à 16, **caractérisé en ce que** la brasure Le dépôt (9) est constitué de soudure SAC.
